(19) **Europäisches Patentamt / European Patent Office / Office européen des brevets**

(11) **EP 4 748 967 A1**

(12) # EUROPEAN PATENT APPLICATION
published in accordance with Art. 153(4) EPC

(43) Date of publication:
**27.05.2026 Bulletin 2026/22**

(21) Application number: **24844711.2**

(22) Date of filing: **19.07.2024**

(51) International Patent Classification (IPC):
***C23C 16/44*** *(2006.01)*

(52) Cooperative Patent Classification (CPC):
**B08B 7/00; C23C 16/44; C23C 16/52; H10P 72/00**

(86) International application number:
**PCT/CN2024/106366**

(87) International publication number:
**WO 2025/021019 (30.01.2025 Gazette 2025/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.07.2023 CN 202310906586**

(71) Applicant: **Beijing NAURA Microelectronics Equipment Co., Ltd.**
**Beijing 100176 (CN)**

(72) Inventor: **HE, Yunfei**
**Beijing 100176 (CN)**

(74) Representative: **Cohausz & Florack**
**Patent- & Rechtsanwälte**
**Partnerschaftsgesellschaft mbB**
**Bleichstraße 14**
**40211 Düsseldorf (DE)**

(54) **CLEANING METHOD FOR PROCESS CHAMBER AND SEMICONDUCTOR PROCESS DEVICE**

(57) A cleaning method for a processing chamber and a semiconductor processing device are provided. The method comprises: cleaning the processing chamber using plasma; acquiring opening size information of a flow control valve of an exhaust assembly configured for evacuating the processing chamber; and stopping the cleaning when the opening size information meets a preset condition. **In** the present disclosure, the endpoint of the cleaning process for the processing chamber can be determined accurately and in real time. Once the cleaning process reaches its endpoint, the cleaning operation is stopped, thereby avoiding both insufficient cleaning and over-cleaning of the processing chamber.

EP 4 748 967 A1

FIG. 2

**Description**

**FIELD OF THE INVENTION**

The present disclosure relates to the field of semiconductor manufacturing, and in particular, to a cleaning method for a processing chamber and a semiconductor processing device.

**BACKGROUND OF THE INVENTION**

In semiconductor manufacturing processes, while a film layer is deposited on the substrate, by-products from the reaction are simultaneously generated and deposited on inner surfaces of the processing chamber. Over time, these by-products adhere to the sidewalls of the chamber. As the process continues, the by-products may crack or peel off, which can easily result in excessive debris particle contamination within the film layer on the wafer. Consequently, product yield may be adversely affected. Therefore, after each deposition process, it is necessary to clean or maintain the processing chamber.

Currently, the common cleaning practice is to introduce fluorine-containing gases (for example, $CF_4$, $C_2F_6$, or $NF_3$) into the processing chamber. These gases dissociate in the chamber to produce active fluorine radicals (F*). The fluorine radicals can chemically react with the reaction's by-products deposited on the chamber sidewalls (such as SiO, SiN, or SiON). As a result, gaseous silicon tetrafluoride ($SiF_4$) is formed and discharged through the exhaust port of the processing chamber, thereby achieving the cleaning effect. Nevertheless, the timing of cleaning completion is particularly critical. If the cleaning is not frequent, particles within the film layer are likely to increase. Conversely, if the cleaning is excessive, the processing chamber itself may be damaged.

Accordingly, there is an urgent need in the field to provide a cleaning method that can accurately control the cleaning endpoint.

**SUMMARY OF THE INVENTION**

The present disclosure proposes a cleaning method for a processing chamber and a semiconductor processing device, which enable accurate control of the cleaning endpoint.

A first embodiment of the present disclosure provides a cleaning method for a processing chamber, comprising:

cleaning the processing chamber using a plasma;

acquiring opening size information of a flow control valve of an exhaust assembly in the processing chamber, wherein the exhaust assembly is configured for evacuating the processing chamber; and

stopping the cleaning when the opening size information meets a preset condition.

As an example, the opening size information comprises an opening size value of the flow control valve. The preset condition comprises the opening size value gradually decreasing from a high point value to a relatively stable value.

As an example, the opening size information comprises an opening size variation amount, and the opening size information is acquired by:

acquiring opening size values of the flow control valve at different moments; and

calculating a derivative of the opening size values at different moments, to obtain opening size variation amounts of the flow control valve at different moments. The opening size variation amounts are the first derivatives of the opening size values.

As an example, the preset condition comprises: after a predetermined duration, an absolute value of one of the opening size variation amounts is less than a first preset threshold.

As an example, the opening size information further comprises second derivatives of the opening size values.

After obtaining the opening size variation amounts of the flow control valve at the different moments, the cleaning method further comprises:
calculating a derivative of the opening size variation amounts at different moments, to obtain the second derivatives of the opening size values of the flow control valve at different moments.

As an example, the preset condition comprises:

an absolute value of one of the second derivatives of the opening size values is less than a second preset threshold; or

absolute values of the opening size variation amounts at consecutive moments are less than a first preset threshold and absolute values of the second derivatives of the opening size values at the consecutive moments are less than the second preset threshold.

As an example, the method further comprises:

before calculating a derivative of the opening size values at different moments, performing a filtering process on the opening size values of the flow control valve; and

after obtaining the opening size variation amounts of the flow control valve at different moments (i.e., before calculating a derivative of the opening size variation amounts at different moments), performing a filtering process on the opening size variation amounts of the flow control valve.

As an example, the opening size values of the flow control valve are filtered using calculation by the equation:

$$Y_n = aX_n + bY_{n-1};$$

where $X_n$ represents an opening size value of the flow control valve at a moment of $t_n$, $Y_{n-1}$ represents a filtered opening size value of the flow control valve at a previous moment of $t_{n-1}$, $Y_n$ represents a filtered opening size value of the flow control valve at a moment of $t_n$, and wherein a and b are configured as constants.

As an example, cleaning the processing chamber using a plasma comprises:
introducing the plasma into the processing chamber; and cleaning the processing chamber using the plasma.

A second embodiment of the present disclosure provides a semiconductor processing device, comprising:

a processing chamber;

an exhaust assembly, wherein the exhaust assembly is in communication with the processing chamber and configured for evacuating the processing chamber, wherein the exhaust assembly comprises a flow control valve; and

a controller, wherein the controller comprises at least one processor and at least one memory device, and a computer program is stored on the memory, wherein when the processing chamber is cleaned using the plasma, the processor executes the computer program to:

acquire opening size information of the flow control valve; and

stop the cleaning when the opening size information meets a preset condition.

The present disclosure offers the following beneficial effects.

In the present disclosure, the cleaning method acquires the opening size information of the flow control valve. When the opening size information meets the preset condition, it is determined that the cleaning process of the processing chamber has reached its endpoint, and the cleaning operation is stopped. This approach enables real-time and accurate control of the timing of the cleaning endpoint, while relying only on existing components of the semiconductor processing device. No structural modifications or additional components are required.

The semiconductor processing device provided in the embodiments of the present disclosure, by executing the above cleaning method for the processing chamber, can control the endpoint of the cleaning process in real time and with accuracy.

**BRIEF DESCRIPTION OF DRAWINGS**

FIG. 1 is a schematic diagram showing a hardware scenario for cleaning a processing chamber according to an embodiment of the present disclosure;

FIG. 2 is a flowchart of a cleaning method for a processing chamber according to an embodiment of the present disclosure;

FIG. 3 is a curve showing the relationship between the content of $SiF_4$ in the processing chamber and the corresponding cleaning duration during the cleaning process of the processing chamber;

FIG. 4 is a curve showing the relationship between the opening size percentage value and the corresponding cleaning duration during the cleaning process of the processing chamber;

FIG. 5 is a curve showing the relationship between the opening size variation amount and the corresponding cleaning duration during the cleaning process of the processing chamber;

FIG. 6 is a curve showing the relationship between the second derivative of the opening size value and the corresponding cleaning duration during the cleaning process of the processing chamber;

FIG. 7 is a flowchart of a cleaning method for a processing chamber according to another embodiment of the present disclosure; and

FIG. 8 is a schematic diagram of a semiconductor processing device according to an embodiment of the present disclosure.

## DETAILED DESCRIPTION OF THE INVENTION

To enable those skilled in the art to better understand the technical solutions of the present disclosure, the cleaning method and the semiconductor processing device provided herein are described in detail below with reference to the accompanying drawings.

Before describing the embodiments of the present disclosure, the technical background is first explained. At present, commonly used methods for cleaning a processing chamber include in-situ plasma cleaning and remote plasma source (RPS) cleaning. Taking in-situ plasma cleaning as an example, its principle is as follows: fluorine-based gases such as $CF_4$ or $C_2F_6$ and oxygen are introduced into the processing chamber. Through a radio frequency system, the fluorine-based gases are dissociated to generate active fluorine radicals (F*) and ions with certain energy. The active fluorine radicals F* undergoes a chemical reaction with the reaction by-product SiO on the sidewalls of the processing chamber according to Equation (1), and undergoes a chemical reaction with the reaction by-product SiN on the sidewalls of the processing chamber according to Equation (2), thereby producing gaseous $SiF_4$. In this way, the sidewalls of the processing chamber are cleaned.

$$\text{Equation (1):} \quad F^*+SiO{\rightarrow}SiF_4{\uparrow}+O;$$

$$\text{Equation (2)} \quad : F^*+SiN{\rightarrow}SiF_4{\uparrow}+N.$$

To achieve an appropriate degree of cleaning of the processing chamber, technicians in the field typically infer the time required to complete one cleaning cycle based on existing data and experience, and design the cleaning duration and frequency as fixed constants. However, due to the influence of other factors, the thickness of the reaction by-products formed on the processing chamber sidewalls often varies. As a result, cleaning the processing chamber using fixed durations and frequencies may still lead to insufficient cleaning or over-cleaning.

As the cleaning process proceeds, the content of gaseous $SiF_4$ in the processing chamber changes. When the cleaning reaches its endpoint, the chemical reactions approach termination, at which time, the content of gaseous $SiF_4$ remains essentially unchanged. Accordingly, related technologies disclose a processing chamber equipped with a concentration detection element and a controller. The concentration detection element can detect the content of $SiF_4$ in the processing chamber, and the controller determines whether the chemical reactions between the active fluorine radicals F* and the reaction by-products on the processing chamber sidewalls have approached termination, based on the detected $SiF_4$ content, thereby judging whether the cleaning endpoint has been reached. In this way, accurate control of the cleaning endpoint can be achieved. For example, the concentration detection element may comprise an infrared emitter and an infrared detector.

Furthermore, in the related technologies, the cleaning endpoint of the processing chamber can be determined by detecting the content of $SiF_4$. This requires the semiconductor processing device to be additionally equipped with concentration detection elements and other structures, which results in a more complex device structure.

In view of this, the present disclosure proposes using the state of components already present in the semiconductor processing device as the basis for determining the cleaning endpoint, wherein the state of such components changes along with the cleaning process of the processing chamber. Based on this concept, the present disclosure provides a cleaning method for a processing chamber and a semiconductor processing device. The method determines whether the cleaning process of the processing chamber has reached its endpoint according to opening size information of a flow control valve of an exhaust assembly configured for evacuating the processing chamber, and controls stopping the cleaning when the cleaning process reaches the endpoint.

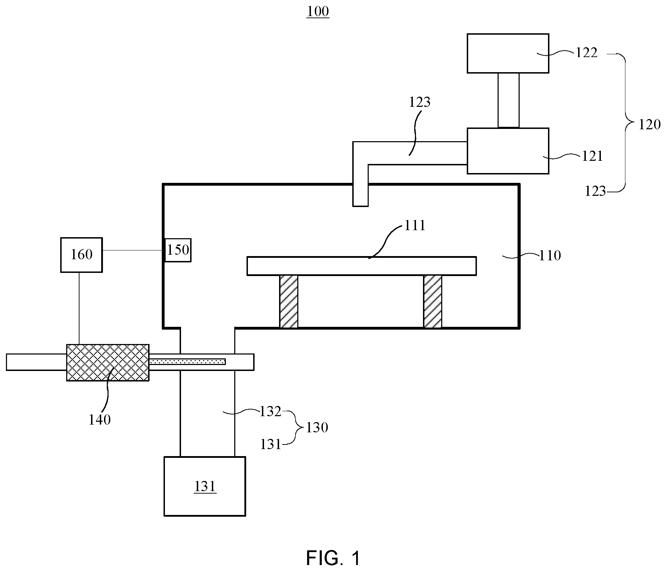

FIG. 1 is a schematic diagram showing a hardware scenario of a cleaning method for a processing chamber according to the present disclosure. Referring to FIG. 1, a semiconductor processing device 100 comprises a processing chamber 110, a remote plasma device 120, an exhaust assembly 130, and a pressure control system. A wafer support 111 is arranged inside the processing chamber 110, and the wafer support 111 is used for placing a wafer to be processed. The processing chamber 110 can be used to perform processing operations such as deposition and etching on the wafer, and the processing chamber 110 is provided with a gas inlet and a gas outlet.

The remote plasma device 120 comprises a remote plasma system 121. The remote plasma system 121 is in communication with the gas inlet through a gas inlet pipeline 123. A gas source 122 arranged outside the processing chamber 110 is configured to provide cleaning gases (such as $CF_4$ or $C_2F_6$) to the remote plasma system 121. The remote plasma system 121 utilizes a radio frequency system to ionize the cleaning gases to generate plasma, and the plasma is delivered into the processing chamber 110 through the gas inlet pipeline 123. It should be understood by those skilled in the art that this solution is described only by taking remote plasma cleaning as an example, and the present disclosure is not limited thereto, and in-situ plasma cleaning may also be performed on the processing chamber.

The exhaust assembly 130 comprises a gas outlet pipeline 132. A first end of the gas outlet pipeline 132 is in communication with the gas outlet of the processing chamber 110, and a second end of the gas outlet pipeline 132 is connected to a vacuum pump 131 arranged outside the processing chamber 110. The vacuum pump 131 is configured to evacuate the processing chamber 110. The exhaust assembly 130 further comprises a flow control valve 140, which is disposed on the gas outlet pipeline 132.

The pressure control system comprises a pressure detection device 150 and a pressure controller 160 that are connected to each other. The pressure detection device 150 is configured to detect the pressure inside the processing chamber 110. The pressure controller 160 controls the flow control valve 140 according to the pressure value detected by the pressure detection device 150, thereby adjusting the opening size of the flow control valve and maintaining a constant pressure inside the processing chamber 110.

It can be understood that when the wafer undergoes a processing operation in the processing chamber 110, reaction by-products are formed not only on the sidewalls of the processing chamber but also deposited on the flow control valve 140. The flow control valve 140 comprises a valve body and a valve plate. The valve plate can move relative to the valve body to open or close the flow control valve, thereby allowing or cutting off communication of the gas outlet pipeline. It should be understood that the reaction by-products deposited on the flow control valve 140 affect the gap allowing the valve plate's relative motion to the valve body, and thus affect the real opening size of the flow control valve 140. Specifically, compared with a flow control valve 140 without deposited reaction by-products, under the same movement distance of the valve plate, a flow control valve 140 with deposited reaction by-products allows only a smaller amount of gas to pass through the gap per unit time.

During the cleaning process of the processing chamber, the reaction by-products deposited on the flow control valve 140 also react with the plasma, thereby achieving cleaning of the flow control valve 140. As a result, the opening size of the flow control valve 140 changes along with the cleaning process of the processing chamber. Specifically, the cleaning process of the processing chamber can be divided into an initial stage, a middle stage, and a final stage.

In the initial stage of the cleaning process, the amount of plasma gas introduced into the processing chamber 110 by the remote plasma device increases, the number of active fluorine radicals (F*) participating in the chemical reactions increases, the content of $SiF_4$ produced rises sharply, and the pressure inside the processing chamber 110 increases rapidly. In the initial stage, a large amount of reaction by-products is deposited on the flow control valve 140, and a significant portion of the gap between the valve body and the valve plate is blocked by the reaction by-products. Overall, in the initial stage of the cleaning process, while the amount of gas in the processing chamber 110 increases, the gap between the valve body and the valve plate is relatively small. Therefore, in order to maintain constant pressure inside the processing chamber 110, the pressure controller 160 increases the opening size of the flow control valve 140.

In the middle stage of the cleaning process, the reaction by-products on the sidewalls of the processing chamber 110 and on the flow control valve 140 are gradually cleaned away. The amount of plasma gas introduced into the processing chamber 110 by the remote plasma device gradually decreases, the number of active fluorine radicals F* participating in the chemical reactions decreases, the content of $SiF_4$ decreases, and the pressure inside the processing chamber 110 correspondingly drops. In the middle stage, the reaction by-products deposited on the flow control valve 140 are gradually reduced, and the portion of the gap blocked by the reaction by-products becomes relatively small. Overall, in the middle stage of the cleaning process, while the amount of gas in the processing chamber 110 decreases, the valve plate is cleaned so the gap between the valve body and the plate increases. Therefore, in order to maintain constant pressure inside the processing chamber 110, the pressure controller 160 decreases the opening size of the flow control valve 140.

In the final stage of the cleaning process, the reaction by-products on the sidewalls of the processing chamber 110 are completely removed, the chemical reactions approach termination, the amount of plasma gas introduced into the processing chamber 110 by the remote plasma device becomes stable, the content of $SiF_4$ no longer changes, and the pressure inside the processing chamber 110 tends to remain constant. In the final stage, the reaction by-products deposited on the flow control valve 140 are completely removed, and the gap between the valve body and the valve plate is no longer blocked by reaction by-products. Overall, in the final stage of the cleaning process, while the amount of gas in the processing chamber 110 tends to stabilize, there are no longer any reaction by-products blocking the gap between the valve body and the valve plate. Therefore, the pressure controller 160 maintains the opening size of the flow control valve 140 at a constant level.

Based on the above application arrangement structure, the present disclosure provides a cleaning method for a processing chamber. It should be understood that the execution subject of this cleaning method may be a semiconductor processing device, or may be an electronic device capable of controlling the semiconductor processing device, such as a computer server.

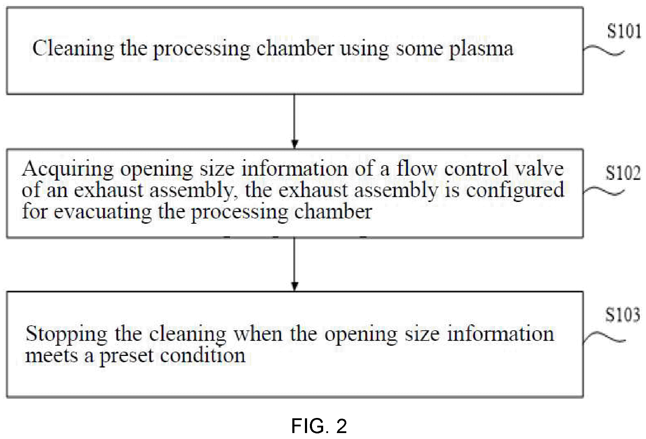

FIG. 2 is a flowchart of the cleaning method for a processing chamber according to the present disclosure. Referring to FIG. 2, the cleaning method disclosed in the present disclosure mainly comprises steps S101 to S103.

Step S101 comprises cleaning the processing chamber using some plasma.

Step S102 comprises acquiring opening size information of a flow control valve of an exhaust assembly. The exhaust assembly is configured for evacuating the processing chamber.

The flow control valve is not limited to a butterfly valve, but may also be a stop valve, a gate valve, or other types of flow valves.

Step S103 comprises stopping the cleaning when the opening size information meets a preset condition.

As described above, when the processing chamber is cleaned using the plasma, the amount of plasma gas in the chamber and the content of $SiF_4$ generated by chemical reactions in the chamber are positively correlated with the amount of gas in the chamber. The amount of gas in the chamber and the amount of reaction by-products deposited on the flow control valve are positively correlated with the opening size value of the flow control valve. When the cleaning process of the processing chamber reaches its endpoint, the chemical reactions stop, the amount of gas in the chamber tends toward a constant value, and no reaction by-products block the gap between the valve body and the valve plate, at which time, the opening size value of the flow control valve remains essentially unchanged.

It can thus be seen that the opening size information of the flow control valve changes along with the cleaning process of the processing chamber, and in the final stage of the cleaning process, the opening size value of the flow control valve remains constant. Therefore, in step S103, when the opening size information meets a preset condition, it indicates that the cleaning process of the processing chamber has reached its endpoint, and the cleaning can be stopped.

Based on the cleaning method provided in the present disclosure, the endpoint of the cleaning process can be determined in real time and with accuracy. When it is determined that the cleaning process of the processing chamber has ended, the cleaning operation is stopped, thereby preventing over-cleaning or insufficient cleaning of the processing chamber.

Moreover, the cleaning method provided in the present disclosure is implemented based on the flow control valve and the pressure control system. Since both the flow control valve and the pressure control system are existing components of the semiconductor processing device, this avoids structural modifications or the addition of new components that would otherwise increase complexity and cost.

It should be understood that the preset condition varies depending on the limiting of the opening size information.

As an example, the opening size information refers to the opening size value of the flow control valve. The preset condition may specifically be that the opening size value gradually decreases from a high point to a relatively stable value. The high point refers to a relatively high value. The relatively stable value refers to a lower value that remains essentially equal across multiple consecutive moments, including the current moment. That is, the opening size value of the flow control valve remains unchanged across multiple consecutive moments. According to the description above, this indicates that the cleaning process of the processing chamber has reached its endpoint, and the cleaning can be stopped.

The opening size value of the flow control valve specifically refers to the relative opening (Unit: ‰), i.e., the ratio of the flow allowed through the valve at a given opening to the flow allowed when the valve is fully open. The opening size value of the flow control valve may be acquired by a collection module. For example, the collection module may be an opening meter. Alternatively, the collection module may be an angle sensor disposed on the valve plate of the flow control valve, or an encoder disposed on the motor shaft that drives the rotation of the valve plate. The encoder is used to collect the angular displacement of the valve plate, which can be converted into the opening size value of the flow control valve.

As another example, the opening size information may comprise an opening size variation amount. The opening size variation amount may be expressed as the first derivative of the curve of the opening size value of the flow control valve with respect to time, and is used to reflect the rate of change of the opening size value of the flow control valve over time.

At this time, step S102 may comprise steps S1021 and S1022.

Step S1021 comprises acquiring opening size values of the flow control valve at different moments.

Step S1022 comprises calculating a derivative of the opening size values at different moments, to obtain opening size variation amounts of the flow control valve at different moments. The opening size variation amounts are first derivatives of the opening size values.

As an example, in step S1022, the opening size variation amounts may be obtained as follows: the opening size values of the flow control valve at n moments are arranged to form multiple sets of data $(t_1, X_1)$, $(t_2, X_2)$, $(t_3, X_3)$, ..., $(t_n, X_n)$, where n is a positive integer and $X_n$ is the opening size value of the flow control valve at moment $t_n$. By fitting these data sets, a curve of the opening size value versus time can be generated. Based on this curve, an opening function is established. Taking the first derivative of the opening function yields the first derivative, and the value (i.e., the first derivative value) of the first derivative at a given moment represents the opening size variation amount of the flow control valve at that moment.

In another example, since the meaning of the first derivative of the opening size value at a given moment is the rate of change of the opening size value near that moment, the opening size variation amount may also be obtained by determining the rate of change of the opening size value near each moment. In this case, step S1022 may specifically determine the opening size variation amounts at different moments according to Equation (3). Here, $X_n'$ represents the opening size variation amount of the flow control valve at moment $t_n$, and n is a positive integer.

$$\text{Equation (3): } X_n' = \frac{X_n - X_{n-1}}{t_n - t_{n-1}}.$$

Because the opening size values are acquired in real time during the cleaning process of the processing chamber, before the cleaning process reaches its endpoint, determining the opening size variation amount based on the rate of change of the opening size value near each moment yields higher accuracy.

As a further optional example, the opening size value of the flow control valve may be acquired at intervals of a set duration. Here, $t_n - t_{n-1} = \Delta t$, where $\Delta t$ is a positive constant. Illustratively, $\Delta t$ may be set to 0.2s, meaning that the opening size value of the flow control valve is acquired every 0.2 s. This helps further reduce the computational load of determining the opening size variation amount.

Exemplarily, the preset condition may specifically be that, after a predetermined duration, the absolute value of the opening size variation amount is less than a first preset threshold. Step S103 specifically comprises: after the predetermined duration, when the absolute value of the opening size variation amount of the flow control valve is less than the first preset threshold, stopping the cleaning of the processing chamber.

It should be understood that the present disclosure does not limit the predetermined duration, which may be, for example, 5s, 10s, etc. By reasonably designing the predetermined duration, the opening size value of the flow control valve is ensured to be on the descending edge, i.e., gradually decreasing, and cleaning is stopped only when the absolute value of the opening size variation amount is less than the first preset threshold. This helps avoid misjudging the endpoint of the cleaning process in cases where the opening size value reaches a peak, the first derivative of the opening size value is zero, and the opening size variation amount is also less than the first preset threshold.

The first preset threshold is a positive number close to zero, and may be designed based on experience and actual operating conditions. For example, the first preset threshold may be 0.0002, 0.0004, 0.0006, 0.0008, or 0.001. Compared with setting the preset condition as the opening size variation amount equal to zero, the benefit of this design is that the opening size variation amount is allowed to fall within a preset range to meet the preset condition. For instance, if the first preset threshold is set to 0.001, the preset range is [-0.001, +0.001]. In this way, the opening size variation amount is allowed to have a reasonable error, which helps reduce the precision requirements of the collection module.

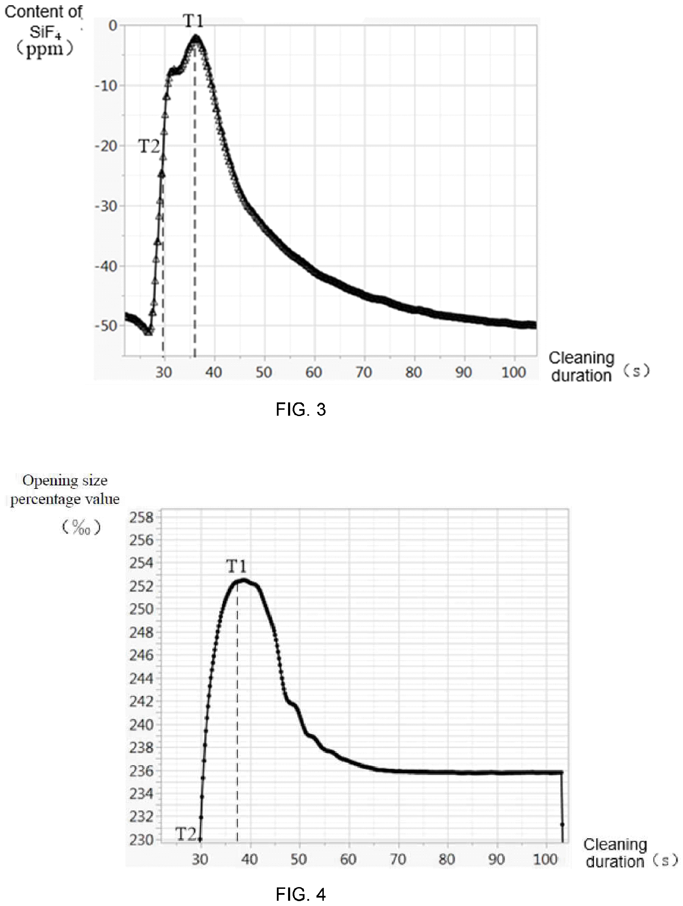

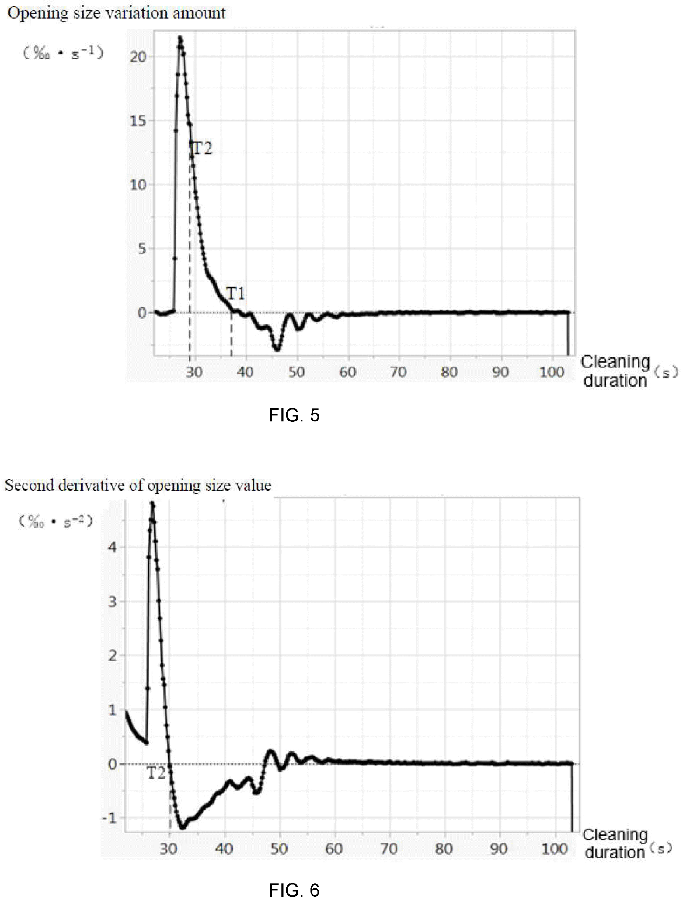

As described above, the content of $SiF_4$ is positively correlated with the opening size value of the flow control valve. Here, during the cleaning of the processing chamber, the opening size values of the flow control valve are detected and recorded, while the cleaning method of the present disclosure is simulated to determine the opening size values and opening size variation amounts of the flow control valve at different moments. At the same time, the content of $SiF_4$ in the processing chamber during cleaning is recorded. By determining whether the content of $SiF_4$ is positively correlated with the opening size value of the flow control valve, the effectiveness of the cleaning method provided in the present disclosure can be verified. By fitting the content of $SiF_4$ in the processing chamber, the opening size values, and the opening size variation amounts with the corresponding moments to form curves, FIG. 3, FIG. 4, and FIG. 5 can be obtained. FIG. 3 is a curve showing the relationship between the content of $SiF_4$ in the processing chamber and the corresponding cleaning duration during the cleaning process. FIG. 4 is a curve showing the relationship between the opening size value and the corresponding cleaning duration during the cleaning process. FIG. 5 is a curve showing the relationship between the opening size variation amount and the corresponding cleaning duration during the cleaning process. The cleaning duration corresponding to a given moment is the time interval between that moment and the starting moment of the cleaning process of the processing chamber.

From FIG. 5 it can be seen that, at the moment corresponding to a cleaning duration of 90 seconds, the opening size variation amount of the flow control valve is zero. This means that the opening size value of the flow control valve has essentially not changed at that moment, thereby meeting the preset condition. In combination with FIG. 3 and FIG. 4, it can be observed that at this moment the content of $SiF_4$ in the processing chamber and the opening size value of the flow control valve both tend to remain constant, indicating that the cleaning process is approaching completion, and the cleaning of the processing chamber can be stopped. Accordingly, it can be understood that the curve graphs obtained by fitting the data from the simulated cleaning process of the processing chamber verify that the cleaning method provided in the present disclosure can accurately determine the endpoint of the cleaning process.

On the basis of the technical solution in which the opening size information comprises the opening size variation amount, the opening size information may further comprise the second derivative of the opening size value. The second derivative of the opening size value may be expressed as the second derivative of the curve of the opening size value with respect to time, or equivalently as the first derivative of the curve of the opening size variation amount with respect to time. Therefore, in one example, after step S1022, step S102 further comprises step S1023.

Step S1023 comprises calculating a derivative of the opening size variation amounts at different moments, to obtain the second derivatives of the opening size values of the flow control valve at different moments.

As an example, in step S1023, the second derivatives of the opening size values may be obtained as follows: the opening size variation amounts of the flow control valve at different moments are arranged to form multiple sets of data. By fitting these data sets, a curve of the opening size variation amount versus time can be generated. Based on this curve, an opening variation function is established. Taking the first derivative of the opening variation function yields the second derivatives of the opening size values.

In another example, the second derivative is the rate of change of the first derivative. The meaning of the first derivative of the opening size variation amount at a given moment is the rate of change of the opening size variation amount near that moment. Therefore, the second derivative of the opening size value may also be obtained by determining the rate of change of the opening size variation amount near each moment. In this case, step S1023 may specifically determine the second derivatives of the opening size values at different moments according to Equation (4). Here, $X_n''$ represents the second derivative of the opening size value of the flow control valve at moment $t_n$.

$$\text{Equation (4): } X_n'' = \frac{X_n' - X_{n-1}'}{t_n - t_{n-1}}.$$

Because the opening size values are acquired in real time during the cleaning process of the processing chamber, before the cleaning process reaches its endpoint, determining the second derivative of the opening size value based on the rate of change of the opening size variation amount near each moment yields higher accuracy.

When the opening size information comprises both the opening size variation amount and the rate of change of the opening size variation amount, the preset condition in step S103 may comprise multiple possible implementations.

In a first possible implementation, the preset condition is that the absolute value of the second derivative of the opening size value is less than a second preset threshold. At this time, step S103 specifically comprises: when the absolute value of the second derivative of the opening size value of the flow control valve is less than the second preset threshold, stopping the cleaning of the processing chamber.

Similar to the first preset threshold, the second preset threshold is also a positive number close to zero. The second preset threshold may be the same as or different from the first preset threshold. For example, the second preset threshold may be 0.001, 0.002, 0.003, 0.004, or 0.005. Compared with setting the preset condition as the opening variation rate equal to zero, the benefit of this design is that the second derivative of the opening size value is allowed to fall within a set range to meet the preset condition. For instance, if the second preset threshold is 0.005, the set range is [-0.005, +0.005]. In this way, the second derivative of the opening size value is allowed to have a reasonable error, which helps reduce the precision requirements of the collection module.

By simulating the cleaning method of the present disclosure, the second derivative of the opening size value at different moments during the cleaning process, as shown in FIG. 5, can be determined. Fitting these values with the corresponding moments yields a curve, shown in FIG. 6. FIG. 6 is a curve graph of the second derivative of the opening size value versus the corresponding cleaning duration during the cleaning process of the processing chamber.

From FIG. 6 it can be seen that, at the moment corresponding to a cleaning duration of 100 seconds, the second derivative of the opening size value of the flow control valve is zero, thereby meeting the preset condition. In combination with FIG. 3 and FIG. 4, it can be observed that at this moment the content of $SiF_4$ in the processing chamber and the opening size value of the flow control valve both tend to remain constant, indicating that the cleaning process is approaching completion, and the cleaning of the processing chamber can be stopped. Accordingly, it can be understood that the curve graphs obtained by fitting the data from the simulated cleaning process of the processing chamber verify that the cleaning method provided in the present disclosure can accurately determine the endpoint of the cleaning process.

In a second possible implementation, the preset condition is that the absolute value of the opening size variation amount is less than the first preset threshold for multiple consecutive moments, and the absolute value of the second derivative of the opening size value is less than the second preset threshold for multiple consecutive moments. At this time, step S103 specifically comprises: when the absolute value of the opening size variation amount of the flow control valve is less than the first preset threshold for multiple consecutive moments, and the absolute value of the second derivative of the opening size value of the flow control valve is less than the second preset threshold for multiple consecutive moments, stopping the cleaning.

It should be noted that when the preset condition is only that the absolute value of the opening size variation amount is less than the first preset threshold, referring to FIG. 5, at cleaning duration $T_1$, the opening size variation amount of the flow control valve is zero, thereby meeting the preset condition. In combination with FIG. 3 and FIG. 4, however, at this time the content of $SiF_4$ in the processing chamber and the opening size value of the flow control valve are both at their maximum values, and the cleaning process of the processing chamber has not yet reached its endpoint. When the preset condition is only that the absolute value of the second derivative of the opening size value is less than the second preset threshold, referring to FIG. 6, at cleaning duration $T_2$, the second derivative of the opening size value is zero, thereby meeting the preset condition. In combination with FIG. 3, FIG. 4, and FIG. 5, however, at this time the content of $SiF_4$ in the processing chamber and the opening size value of the flow control valve increase sharply, and the opening size variation amount of the flow control valve approaches its maximum value. The cleaning process of the processing chamber is still in its initial stage and has not yet reached its endpoint.

It can thus be seen that when the preset condition is only that the absolute value of the opening size variation amount is less than the first preset threshold, or only that the absolute value of the second derivative of the opening size value is less than the second preset threshold, there is a possibility of misjudging the endpoint of the cleaning process of the processing chamber. The preset condition of the present disclosure combines the preset conditions of the two possible implementations described above, which helps avoid misjudgment of the cleaning endpoint and further improves the accuracy of determining the endpoint of the cleaning process of the processing chamber.

It is noteworthy that by setting the preset condition as the absolute value of the opening size variation amount being less than the first preset threshold for multiple consecutive moments and the absolute value of the second derivative of the opening size value being less than the second preset threshold for multiple consecutive moments, on the one hand, multiple determinations of the opening size variation amount and the second derivative of the opening size value at different moments are required, thereby increasing the number of determinations and improving accuracy. On the other hand, by determining the opening size variation amount or the opening variation rate for multiple consecutive moments including the current moment, misjudgment of the cleaning endpoint can be avoided, greatly improving the accuracy of determining the endpoint of the cleaning process of the processing chamber.

As an optional implementation, step S1024 may be performed before step S1022.

Step S1024 comprises performing a filtering process on the opening size values of the flow control valve.

That is, the opening size values of the flow control valve are first subjected to filtering processing, and then the filtered opening size values are derived to obtain the opening size variation amounts of the flow control valve at different moments. In this way, random interference that may exist during the collection process can be effectively reduced, thereby improving the accuracy of calculating the opening size variation amounts.

Specifically, the opening size values of the flow control valve may be subjected to filtering processing according to Equation (5). In Equation (5), $X_n$ is the opening size value of the flow control valve at moment $t_n$, $Y_{n-1}$ is the filtered opening size value of the flow control valve at moment $t_{n-1}$, $Y_n$ is the filtered opening size value of the flow control valve at moment $t_n$, and a and b are constants, the sum of which may be 1.

$$\text{Equation (5): } Y_n = aX_n + bY_{n-1} = aX_n + (1-a)Y_{n-1}.$$

Accordingly, a correspondence table of the opening size values of the flow control valve at different moments and the filtered opening size values at each moment can be obtained, as shown in Table 1.

Table 1

| Moment | Opening size value | Filtered opening size value |
|---|---|---|
| $t_1$ | $X_1$ | $Y_1 = X_1$ |
| $t_2$ | $X_2$ | $Y_2 = aX_2 + (1-a)Y_1$ |
| $t_3$ | $X_3$ | $Y_3 = aX_3 + (1-a)Y_2$ |
| …… | …… | …… |
| $t_n$ | $X_n$ | $Y_n = aX_n + (1-a)Y_{n-1}$ |

From Table 1 it can be seen that the filtered opening size value of the flow control valve at each moment corresponds to the opening size value at that moment.

It should be noted that the value of a may be designed based on experience and actual operating conditions. The smaller the value of a, the better the filtering effect. For example, a may be selected as 0.1.

As described above, as an example, the opening size variation amounts in step S1022 may be determined according to Equation (6), where $Y_n'$ is the opening size variation amount of the flow control valve at moment $t_n$.

$$\text{Equation (6): } Y_n' = \frac{Y_n - Y_{n-1}}{t_n - t_{n-1}}.$$

Of course, in the present disclosure, other filtering models may also be used to filter the opening size values. In comparison, the cleaning method provided in the present disclosure uses Equation (5) for filtering, which requires less computation while minimizing changes to the collected opening size values.

Similarly, before deriving the opening size variation amounts, the opening size variation amounts may also be subjected to filtering processing. Specifically, as an optional implementation, step S1025 may be performed after step S1022 and before step S1023.

Step S1025 comprises performing a filtering process on the opening size variation amounts of the flow control valve.

In this design, the cleaning method of the present disclosure first filters the opening size variation amounts and then derives the filtered opening size variation amounts to obtain the second derivative of the opening size value of the flow control valve at different moments. In this way, random interference that may exist during the collection process can be further reduced, thereby improving the accuracy of calculating the second derivative of the opening size value.

The filtering method for the opening size variation amounts may be various. For example, it may be similar to the filtering method for the opening size values. Specifically, the opening size variation amounts of the flow control valve may be filtered according to Equation (7). In Equation (7), $Z_n'$ is the filtered variation amount of the flow control valve at moment $t_n$, and c and d are constants, the sum of which may be 1.

$$\text{Equation (7): } Z_n' = cY_n' + dZ_{n-1}' = cY_n' + (1-c)\ Z_{n-1}'.$$

Accordingly, a correspondence table of the opening size variation amounts of the flow control valve at different moments and the filtered variation amounts at each moment can be obtained, as shown in Table 2.

Table 2

| Moment | Opening size variation amount | Filtered Variation Amount |
|--------|-------------------------------|---------------------------|
| $t_1$ | $Y_1'$ | $Z_1' = Y_1'$ |
| $t_2$ | $Y_2'$ | $Z_2' = cY_2' + (1-c)\ Z_1'$ |
| t3 | $Y_3'$ | $Z_3' = cY_3' + (1-c)\ Z_2'$ |
| …… | …… | …… |
| $t_n$ | $Y_n'$ | $Z_n' = cY_n' + (1-c)\ Z_n\text{-}1'$ |

From Table 2 it can be seen that the filtered variation amount of the flow control valve at each moment corresponds to the opening size variation amount at that moment.

It should be noted that the value of c may be designed based on experience and actual operating conditions. The smaller the value of c, the better the filtering effect. For example, c may be selected as 0.05.

As described above, in one example, the second derivatives of the opening size values in step S1023 may be determined according to Equation (8), where $Y_n''$ is the second derivative of the opening size value of the flow control valve at moment $t_n$.

$$\text{Equation (8): } Y_n'' = \frac{Z_n' - Z_{n-1}'}{t_n - t_{n-1}}.$$

In any of the examples described above, the implementation of step S101 varies depending on whether the cleaning method of the processing chamber is in-situ plasma cleaning or remote plasma cleaning. For example, in the case of remote plasma cleaning, in step S101 plasma is introduced into the processing chamber through a remote plasma device. The plasma reacts with the reaction by-products deposited on the sidewalls of the processing chamber and with the reaction by-products deposited on the flow control valve, thereby removing the reaction by-products and achieving cleaning. At this time, the method of stopping the cleaning in step S103 is to shut down the remote plasma system.

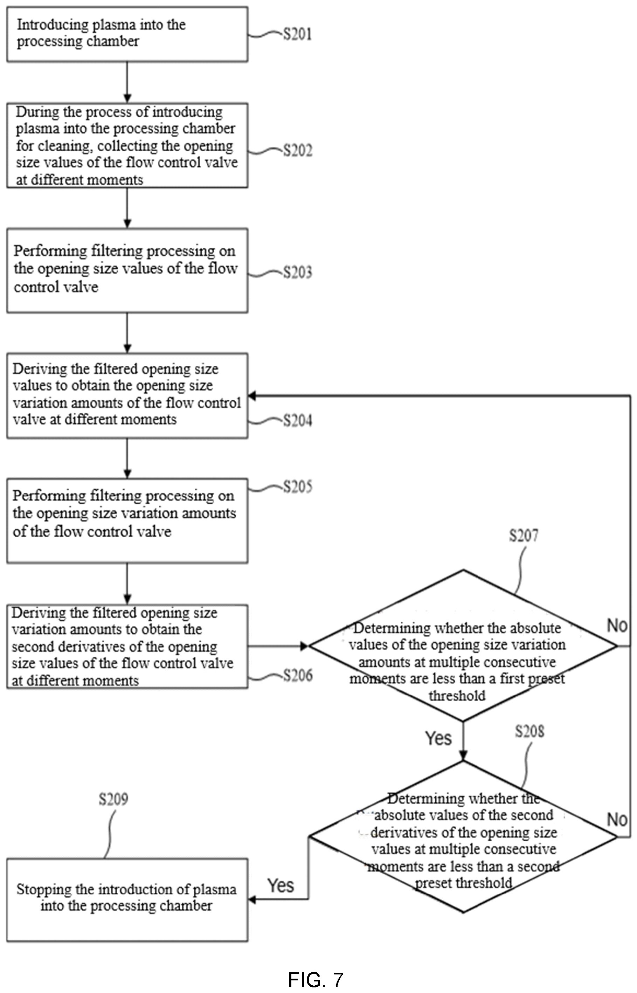

FIG. 7 is a flowchart of the cleaning method for a processing chamber according to another embodiment of the present disclosure. Referring to FIG. 7, in a specific example, the cleaning method comprises steps S201 to S209.

S201 comprises introducing plasma into the processing chamber.

S202 comprises during the process of introducing plasma into the processing chamber for cleaning, collecting the opening size values of the flow control valve at different moments.

S203 comprises performing filtering processing on the opening size values of the flow control valve.

S204 comprises deriving the filtered opening size values to obtain the opening size variation amounts of the flow control valve at different moments.

S205 comprises performing filtering processing on the opening size variation amounts of the flow control valve.

S206 comprises deriving the filtered opening size variation amounts to obtain the second derivatives of the opening size values of the flow control valve at different moments.

S207 comprises determining whether the absolute values of the opening size variation amounts at multiple consecutive moments are less than a first preset threshold; if yes, proceeding to S208; if no, returning to S204.

S208 comprises determining whether the absolute values of the second derivatives of the opening size values at multiple consecutive moments are less than a second preset threshold; if yes, proceeding to S209; if no, returning to S204.

S209 comprises stopping the introduction of plasma into the processing chamber.

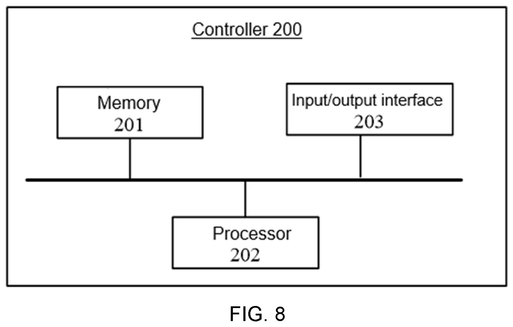

FIG. 8 is a schematic diagram of a semiconductor processing device according to an embodiment of the present disclosure. Referring to FIG. 8, the semiconductor processing device comprises a processing chamber, an exhaust assembly, and a controller 200.

The exhaust assembly is in communication with the processing chamber to evacuate the processing chamber, and the exhaust assembly comprises a flow control valve.

The controller 200 comprises at least one processor 202 and at least one memory 201. The memory 201 is configured to store computer programs. The processor 202, when cleaning the processing chamber using the plasma, is configured to execute the computer program to perform the following steps: acquire opening size information of the flow control valve of the exhaust assembly; and stop cleaning when the opening size information meets a preset condition.

The controller 200 may further comprise an input/output interface 203. The input/output interface 203 may comprise separate output and input interfaces, or may be an integrated interface combining input and output. The output interface is used for outputting data, and the input interface is used for acquiring input data.

As an example, the processor 202 is specifically configured to stop cleaning when the opening size information comprises the opening size value of the flow control valve and the opening size value gradually decreases from a high point value to a relatively stable value.

As an example, the processor 202 is specifically configured, when the opening size information comprises the opening size variation amount, to acquire the opening size values of the flow control valve at different moments, and to derive the opening size values to obtain the opening size variation amounts of the flow control valve at different moments.

As an example, the processor 202 is specifically configured to stop cleaning when, after a predetermined duration, the absolute value of the opening size variation amount is less than a first preset threshold.

As an example, the processor 202 is specifically configured, when the opening size information further comprises the second derivative of the opening size value, to derive the opening size variation amounts after obtaining the opening size variation amounts of the flow control valve at different moments, so as to obtain the second derivatives of the opening size values of the flow control valve at different moments.

As an example, the processor 202 is specifically configured to stop cleaning when the absolute value of the second derivative of the opening size value is less than a second preset threshold; or to stop cleaning when the absolute values of the opening size variation amounts at multiple consecutive moments are less than the first preset threshold and the absolute values of the second derivatives of the opening size values at multiple consecutive moments are less than the second preset threshold.

As an example, the processor 202 is specifically configured to perform filtering processing on the opening size values of the flow control valve before deriving the opening size values; and to perform filtering processing on the opening size variation amounts of the flow control valve after obtaining the opening size variation amounts at different moments.

As an example, the processor 202 is specifically configured to introduce plasma into the processing chamber and to clean the processing chamber using the plasma. In the present disclosure, the semiconductor processing device further comprises a remote plasma device, which is configured to generate plasma and introduce plasma into the processing chamber to clean the processing chamber.

It is understood that the above examples are provided solely to illustrate the principles of the present disclosure and are not intended to limit its scope. Various modifications and improvements may be made by those skilled in the art without departing from the spirit and essence of the application, and such modifications are considered within the scope of the present disclosure.

## Claims

1. A cleaning method for a processing chamber, comprising:

   cleaning the processing chamber using a plasma;
   acquiring opening size information of a flow control valve of an exhaust assembly in the processing chamber, wherein the exhaust assembly is configured for evacuating the processing chamber; and
   stopping the cleaning when the opening size information meets a preset condition.

2. The cleaning method according to claim 1, wherein the opening size information comprises an opening size value of the flow control valve; and
   wherein the preset condition comprises the opening size value gradually decreasing from a high point value to a relatively stable value.

3. The cleaning method according to claim 1, wherein the opening size information comprises an opening size variation amount, and wherein the acquiring the opening size information of the flow control valve of the exhaust assembly in the processing chamber, comprises:

   acquiring opening size values of the flow control valve at different moments; and
   calculating a derivative of the opening size values at different moments, to obtain opening size variation amounts of the flow control valve at different moments.

4. The cleaning method according to claim 3, wherein the preset condition comprises: after a predetermined duration, an absolute value of said opening size variation amount is less than a first preset threshold.

5. The cleaning method according to claim 3, wherein the opening size information further comprises second derivatives of the opening size values; and
   wherein after obtaining the opening size variation amounts of the flow control valve at the different moments, the cleaning method further comprises:
   calculating a derivative of the opening size variation amounts at different moments, to obtain the second derivatives of the opening size values of the flow control valve at different moments.

6. The cleaning method according to claim 5, wherein the preset condition comprises:

   an absolute value of one of the second derivatives of the opening size values is less than a second preset threshold; or
   absolute values of the opening size variation amounts at consecutive moments are less than a first preset threshold and absolute values of the second derivatives of the opening size values at the consecutive moments are less than the second preset threshold.

7. The cleaning method according to any one of claims 3 to 6, wherein before calculating a derivative of the opening size values at different moments, the method further comprises:

   performing a filtering process on the opening size values of the flow control valve; and
   wherein after obtaining the opening size variation amounts of the flow control valve at different moments, the method further comprises:
   performing a filtering process on the opening size variation amounts of the flow control valve.

8. The cleaning method according to claim 7, wherein the opening size values of the flow control valve are filtered by an equation:

$$Y_n = aX_n + bY_{n-1};$$

wherein $X_n$ represents an opening size value of the flow control valve at a moment of $t_n$, $Y_{n-1}$ represents a filtered opening size value of the flow control valve at a previous moment of $t_{n-1}$, $Y_n$ represents a filtered opening size value of the flow control valve at a moment of $t_n$, and wherein a and b are configured as constants.

9. The cleaning method according to any one of claims 1 to 6, wherein cleaning the processing chamber using a plasma comprises:

   introducing the plasma into the processing chamber; and
   cleaning the processing chamber using the plasma.

10. A semiconductor processing device, comprising:

   a processing chamber;
   an exhaust assembly, wherein the exhaust assembly is in communication with the processing chamber and configured for evacuating the processing chamber, wherein the exhaust assembly comprises a flow control valve; and
   a controller, wherein the controller comprises at least one processor and at least one memory, and a computer program is stored on the memory, wherein when the processing chamber is in a cleaning process using a plasma, the processor executes the computer program to:

      acquire opening size information of the flow control valve; and
      stop the cleaning process when the opening size information meets a preset condition.

FIG. 1

| Cleaning the processing chamber using some plasma | S101 |

| Acquiring opening size information of a flow control valve of an exhaust assembly, the exhaust assembly is configured for evacuating the processing chamber | S102 |

| Stopping the cleaning when the opening size information meets a preset condition | S103 |

FIG. 2

FIG. 3

FIG. 4

Opening size variation amount

FIG. 5

Second derivative of opening size value

FIG. 6

FIG. 7

FIG. 8

## INTERNATIONAL SEARCH REPORT

| International application No. |
| --- |
| **PCT/CN2024/106366** |

**A. CLASSIFICATION OF SUBJECT MATTER**

C23C16/44(2006.01)i

According to International Patent Classification (IPC) or to both national classification and IPC

**B. FIELDS SEARCHED**

Minimum documentation searched (classification system followed by classification symbols)

IPC:C23C

Documentation searched other than minimum documentation to the extent that such documents are included in the fields searched

Electronic data base consulted during the international search (name of data base and, where practicable, search terms used)

CNABS, CNTXT, VEN, ENTXT, ENTXTC, USTXT, CJFD, 超星读秀, DUXIU, WPABS, WPABSC: 华创微电子, 贺云菲, 等离子体, 清洗, 刻蚀, 蚀刻, 阀, 开度, 变化率, 导数, 求导, 一阶导, 二阶导, 滤波, 一阶滤波, 低通滤波, 微分, 差分, plasma, clean+, etch+, valve, open, degree, change, derivative, filter+, differential

**C. DOCUMENTS CONSIDERED TO BE RELEVANT**

| Category* | Citation of document, with indication, where appropriate, of the relevant passages | Relevant to claim No. |
| --- | --- | --- |
| X | JP 2010040716 A (SUMITOMO ELECTRIC INDUSTRIES, LTD.) 18 February 2010 (2010-02-18) description, paragraphs 4-38, and figures 2-4 | 1-6, 9-10 |
| Y | JP 2010040716 A (SUMITOMO ELECTRIC INDUSTRIES, LTD.) 18 February 2010 (2010-02-18) description, paragraphs 4-38, and figures 2-4 | 7-8 |
| X | US 6660101 B1 (TOKYO ELECTRON LTD.) 09 December 2003 (2003-12-09) column 1, paragraph 2, column 2, paragraph 5 to column 3, paragraph 6, column 5, paragraphs 1-2, and column 10, paragraph 5 | 1-2, 9-10 |
| Y | US 6660101 B1 (TOKYO ELECTRON LTD.) 09 December 2003 (2003-12-09) column 1, paragraph 2, column 2, paragraph 5 to column 3, paragraph 6, column 5, paragraphs 1-2, and column 10, paragraph 5 | 7-8 |
| X | CN 102339773 A (SHENYANG PIOTECH CO., LTD.) 01 February 2012 (2012-02-01) description, paragraphs 10-20 and 24-31 | 1-2, 9-10 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **23 October 2024** | **24 October 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**EP 4 748 967 A1**

**INTERNATIONAL SEARCH REPORT**

International application No.

**PCT/CN2024/106366**

**C.    DOCUMENTS CONSIDERED TO BE RELEVANT**

| Category* | Citation of document, with indication, where appropriate, of the relevant passages | Relevant to claim No. |
|---|---|---|
| Y | CN 102339773 A (SHENYANG PIOTECH CO., LTD.) 01 February 2012 (2012-02-01) description, paragraphs 10-20 and 24-31 | 7-8 |
| X | JP 2006073751 A (ULVAC CORP.) 16 March 2006 (2006-03-16) description, paragraphs 13-27 | 1-2, 9-10 |
| Y | JP 2006073751 A (ULVAC CORP.) 16 March 2006 (2006-03-16) description, paragraphs 13-27 | 7-8 |
| Y | JP 2020021476 A (SHIMADZU CORP.) 06 February 2020 (2020-02-06) description, paragraphs 5-6 and 70-83 | 7-8 |
| A | CN 113867131 A (WEICHAI POWER CO., LTD.) 31 December 2021 (2021-12-31) entire document | 1-10 |
| A | 贝加莱(中国)技术团队 (B&R (CHINA) TECHNOLOGY TEAM). "一阶惯性滤波介绍 (Non-official translation: Introduction to First-Order Inertial Filtering)" 贝加莱Autimation Studio自动化项目开发指南 (B&R Autimation Studio Project Development Guide), 30 June 2022 (2022-06-30), page 91, paragraphs 1-2 | 8 |
| A | 吴坚等 (WU, Jian et al.). "数据采集系统实例 (Non-official translation: Data Collection System Example)" 计算机控制系统 (Computer Control Systems), 31 August 2002 (2002-08-31), page 53, paragraph 1 | 7-8 |

**INTERNATIONAL SEARCH REPORT**
Information on patent family members

International application No.

**PCT/CN2024/106366**

| Patent document cited in search report | | | Publication date (day/month/year) | Patent family member(s) | | | Publication date (day/month/year) |
|---|---|---|---|---|---|---|---|
| JP | 2010040716 | A | 18 February 2010 | None | | | |
| US | 6660101 | B1 | 09 December 2003 | JP | 2001081545 | A | 27 March 2001 |
| | | | | WO | 0120652 | A1 | 22 March 2001 |
| | | | | TW | 468213 | A | 11 December 2001 |
| CN | 102339773 | A | 01 February 2012 | None | | | |
| JP | 2006073751 | A | 16 March 2006 | None | | | |
| JP | 2020021476 | A | 06 February 2020 | None | | | |
| CN | 113867131 | A | 31 December 2021 | CN | 113867131 | B | 18 June 2024 |

Form PCT/ISA/210 (patent family annex) (July 2022)